# EUROPÄISCHE PATENTANMELDUNG

(11) **EP 0 700 241 A1**
(43) Veröffentlichungstag der Anmeldung: **06.03.1996**
(21) Anmeldenummer: 95113503.7
(22) Anmeldetag: 28.08.1995
(51) Int. Cl.: H05K 5/00, H05K 7/14

(54) **Anordnung zum Anzeigen von Betriebszuständen einschiebbarer elektrischer Baugruppen**

(30) Priorität: 01.09.1994 DE 4431166
(71) Anmelder: SIEMENS AKTIENGESELLSCHAFT, D-80333 München (DE)
(72) Erfinder: Mair, Eduard, D-81475 München (DE)

(57) **Zusammenfassung**

Bei geschirmten Baugruppenträgern mit einer bedienungsseitigen Frontplatte besteht zwischen dieser und den eingeschobenen Baugruppen (3) ein konstruktiv bedingter Abstand. An der Frontkante der Baugruppen (3) sind Leuchtdioden (6) angebracht, die in einem engen Abstrahlwinkel auf Durchbrüche (7) in der Frontplatte (5) gerichtet sind. Diese sind so eng gehalten, daß keine elektromagnetische Störstrahlung hindurchtreten kann. Die Durchbrüche (7) sind mit Streuscheiben (8) verdeckt , an denen das auftreffende Licht als heller Leuchtfleck erscheint, der aus unterschiedlichen Richtungen gut sichtbar ist.

## Beschreibung

Die Erfindung bezieht sich auf eine Anordnung zum Anzeigen von Betriebszuständen einschiebbarer elektrischer Baugruppen, die in einem geschirmten Baugruppenträger aufgenommen sind, der durch eine Frontplatte verschlossen und elektromagnetisch geschirmt ist.

Ein geschirmter Baugruppenträger mit einer als Deckel ausgebildeten Frontplatte ist z.B. durch die DE-C-40 15 926 bekannt geworden. Danach besteht zwischen den Baugruppen und der Frontplatte ein konstruktiv bedingter Abstand.

Bei nicht geschirmten Baugruppen war es üblich, Anzeigeelemente zum Anzeigen der Betriebszustände unmittelbar hinter einer Frontblende der Baugruppe anzubringen, wie dies z.B. in der DE-A-28 46 283 beschrieben ist.

Ferner ist es z.B. in der Unterhaltungselektronik üblich, Anzeigeelemente auf der Innenseite von Gehäuseabdeckungen anzubringen und an diesen entsprechende Durchbrüche vorzusehen. Außerdem werden auch aus Attraktivitätsgründen in die Frontplatte integrierte Lichtleiter verwendet.

Der Erfindung liegt die Aufgabe zugrunde, eine Anordnung zu schaffen, bei der mit geringem Aufwand ein deutlich sichtbare Anzeige der Betriebszustände möglich ist.

Diese Aufgabe wird durch die Erfindung gemäß Anspruch 1 gelöst.

Leuchtdioden mit engem Abstrahlwinkel sind im Handel ohne nennenswerte Mehrkosten erhältlich. Für Frequenzbereiche bis zu 1000 MHz können in die Abdeckungen Durchbrüche bis zu 5 mm Durchmesser eingebracht werden, ohne die Schirmwirkung zu verringern. Die Streuscheibe kann als feste Platte oder auch Folie ausgebildet sein. Ihre matte Struktur ergibt einen hellen Lichtfleck, der aufgrund der Streuwirkung aus allen Richtungen gut sichtbar ist. Für die Überbrückung der freien Strecke zwischen der Baugruppe und der Frontplatte ist keinerlei Aufwand erforderlich. Die Streuscheibe stellt ebenfalls ein einfaches kostengünstiges Element dar.

Nach einer vorteilhaften Weiterbildung der Erfindung ist die Weite des Durchbruchs kleiner als der Durchmesser des Lichtkegels am Durchbruch. Dadurch wird der Durchbruch auch bei fertigungs- und toleranzbedingten Lageabweichungen zwischen dem Lichtkegel und dem Durchbruch vollflächig beleuchtet.

Nach einer anderen Weiterbildung der Erfindung ist für mehrere einander benachbarte Durchbrüche eine gemeinsame Streuscheibe von entsprechender Fläche an der Frontplatte angebracht, wodurch sich die Kosten für die Anbringung verringern.

Nach einer anderen Weiterbildung der Erfindung ist auf der der Leuchtdiode abgewandten Seite der Frontplatte ein Klebeschild aufgeklebt, das mit informativen Zeichen beschriftet ist und das im Bereich der Durchbrüche als Streuscheibe ausgebildet ist. Die informativen Zeichen können z.B. neben Typenbezeichnungen auch die einzelnen Durchbrüche mit entsprechenden Angaben kennzeichnen. Das Klebeschild kann z.B. durchgehend transparent und mattiert sein. Es ist aber auch möglich, das Klebeschild außer an den Durchbrüchen durchgehend mit einer kontrastierenden Farbschicht zu versehen, auf die die informativen Zeichen aufgebracht sind.

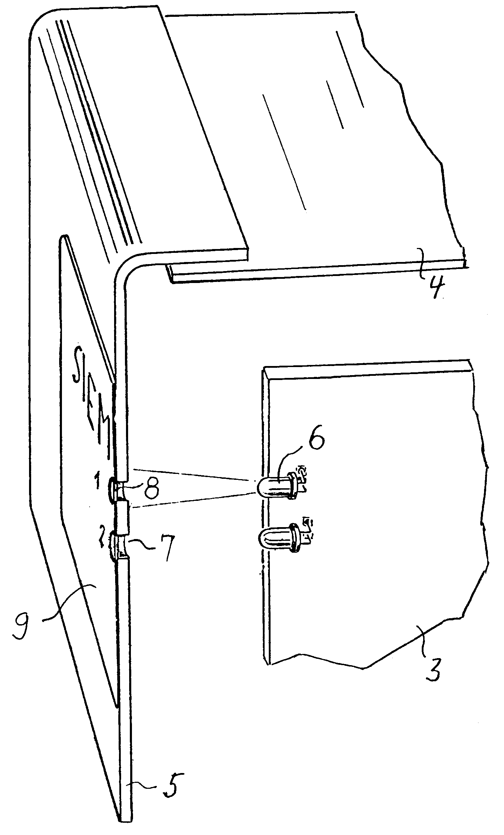

Im folgenden wird die Erfindung anhand eines in der Zeichnung dargestellten Ausführungsbeispiels näher erläutert. Die schematisiert dargestellte Figur zeigt perspektivisch einen Teil eines Baugruppenträgers mit einer einschiebbaren elektrischen Baugruppe 3, einer Gehäusewand 4 und einer bedienungsseitig angebrachten deckelartigen Frontplatte 5. Zwischen der Baugruppe 3 und der Frontplatte 5 besteht ein konstruktiv bedingter Abstand von z.B. 25 mm.

Die Baugruppe 3 ist an ihrer der Frontplatte zugewandten Kante zur Anzeige von Betriebszuständen mit Leuchtdioden 6 bestückt, die in einem engen Winkel in die Richtung der Frontplatte 5 strahlen. Diese ist innerhalb des Strahlungswinkels mit Druchbrüchen 7 versehen, die an der Außenseite mit einer Streuscheibe 8 verdeckt sind. Die Durchbrüche 7 sind so eng gehalten, daß elektromagnetische Störstrahlung nicht hindurchtreten kann. Die matte Struktur der transparenten Streuscheibe und das eng gebündelte Licht der Leuchtdiode 6 lassen die Streuscheibe als hellen Fleck erscheinen, der aus allen Richtungen gut sichtbar ist. Die Streuscheibe ist Teil eines Klebeschildes 9, daß aus mattierten, transparenten Material besteht. Es ist mit Ausnahme der Durchbrüche mit einer Farbschicht bedeckt, auf die informative Zeichen aufgebracht sind. Diese enthalten z.B. Firmen und Typenbezeichnungen, insbesondere aber auch Markierungen, die die einzelnen Leuchtdioden kennzeichnen.

## Patentansprüche

1. Anordnung zum Anzeigen von Betriebszuständen einschiebbarer elektrischer Baugruppen (3) die in einem geschirmten Baugruppenträger aufgenommen sind, der durch eine Frontplatte (5) verschlossen und elektromagnetisch geschirmt ist, mit Leuchtdioden (6) als Lichtquelle, wobei zwischen der Baugruppe (3) und der Frontplatte (5) ein konstruktiv bedingter Abstand besteht,
**dadurch gekennzeichnet,**
daß die einen engen Abstrahlwinkel aufweisende Leuchtdiode (6) an der Baugruppe angebracht ist,
daß im Abstrahlbereich der Leuchtdiode (6) in der Frontplatte (5) ein Durchbruch (7) vorgesehen ist, dessen Weite so gering ist, daß die Schirmwirkung der Frontplatte (5) nicht beeinträchtigt wird,
und daß der Durchbruch (7) mit einer transparenten Streuscheibe (8) verdeckt ist.

2. Anordnung nach Anspruch 1,
**dadurch gekennzeichnet,**
daß die Weite des Durchbruchs (7) kleiner ist als der Durchmesser des Lichtkegels der Leuchtdiode (6) am Durchbruch (7).

3. Anordnung nach Anspruch 1 oder 2,
**dadurch gekennzeichnet,**
daß für mehrere benachbarte Durchbrüche (7) eine gemeinsame Streuscheibe (8) von entsprechender Fläche an der Frontplatte (5) angebracht ist.

4. Anordnung nach Anspruch 3,
**dadurch gekennzeichnet,**
daß auf die der Baugruppe (3) abgewandte Außenseite der Frontplatte (5) ein Klebeschild (9) aufgeklebt ist, das mit informativen Zeichen beschriftet ist, und das im Bereich der Durchbrüche (7) als Streuscheibe (8) ausgebildet ist.
